Europäisches Patentamt

European Patent Office

Office européen des brevets

(19)

(11) Veröffentlichungsnummer : **0 064 744**
**B1**

(12) EUROPÄISCHE PATENTSCHRIFT

(45) Veröffentlichungstag der Patentschrift :
28.08.85

(21) Anmeldenummer : 82103997.1

(22) Anmeldetag : 07.05.82

(51) Int. Cl.⁴ : **G 03 F 7/26, C 25 F 3/02,
H 01 J 31/12**

(54) **Verfahren zur galvanischen und ätztechnischen Strukturierung von Scheiben mit isolierenden Ringzonen im Mündungsbereich von Bohrungen.**

(30) Priorität : 08.05.81 DE 3118335
26.01.82 DE 3202447

(43) Veröffentlichungstag der Anmeldung :
17.11.82 Patentblatt 82/46

(45) Bekanntmachung des Hinweises auf die Patenterteilung : 28.08.85 Patentblatt 85/35

(84) Benannte Vertragsstaaten :
AT BE CH FR GB IT LI LU NL SE

(56) Entgegenhaltungen :
CH-A- 591 570
DE-A- 2 427 610
DE-A- 2 803 762
DE-B- 2 828 625

(73) Patentinhaber : **Siemens Aktiengesellschaft
Berlin und München Wittelsbacherplatz 2
D-8000 München 2 (DE)**

(72) Erfinder : **Trausch, Günter, Dipl.-Ing.
Feldafinger Strasse 39
D-8000 München 71 (DE)**

## Beschreibung

Beim flachen Plasmabildschirm nach der DE-B-24 12 869 wird für jeden Bildpunkt der Elektronenstrom aus dem Plasmaraum zum Leuchtstoff des Bildschirmes durch eine Elektrodenmatrix, die auf der sogenannten Steuerscheibe aufgebracht ist, reguliert. Die Steuerscheibe ist etwas größer als der Bildschirm und besteht aus Glas, das mit Durchgangsbohrungen im Raster der Bildpunkte versehen und beidseitig mit metallischen Leiterbahnen belegt ist.

Zur Verbesserung der Steuereigenschaften kann man zwischen Steuerscheibe und Bildschirm zwei zusätzliche Elektrodenebenen (Tetrode, Pentode) anbringen, die sich auf einer weiteren Glasscheibe befinden. Beide Scheiben können aus Dünnglas (z. B. 0,2 mm Stärke) oder Fotoformglas (z. B. 1 mm Stärke) bestehen oder es kann ein Fotoformglas und ein Dünnglas kombiniert werden.

Bei Verwendung von Fotoformglas müssen die Bohrungswände ebenfalls metallisiert werden. Die Metallisierung muß jedoch auf eine im Verhältnis zur Bohrungstiefe kurze Distanz an definierter Stelle unterbrochen sein. Dieser Ringisolator soll in der Regel den engsten Bohrungsquerschnitt enthalten, so daß er bei zweiseitig geätztem Fotoformglas in Bohrungsmitte, bei einseitiger Ätzung direkt unter der Elektrodenebene mit den kleineren Bohrungsmündungen liegt. Wegen der Feinheit und Vielzahl der Bohrungen ist die Herstellung dieser isolierenden Ringzonen schwierig.

Der Erfindung liegt die Aufgabe zugrunde, ein Verfahren anzugeben, mit dem sich derartige isolierende Ringzonen im Bereich der Bohrungsmündung sicher erzeugen lassen. Diese Aufgabe wird dadurch gelöst, daß die gesamte Scheibenoberfläche einschließlich der Bohrungswände in an sich bekannter Weise, zum Beispiel durch Sputtern, mit einer dünnen Metallschicht überzogen wird, anschließend die Scheibenseite, unter deren Oberfläche isolierende Ringzonen erzeugt werden sollen, mit einem Negativ-Trockenresist (Fotofolie) so kaschiert wird, daß ein Teil des Resists auch in die Bohrungen eindringt, daß ferner der Resist in den Bohrungen von der gegenüberliegenden Seite her durch die Bohrungen mit UV-Licht bestrahlt und zur Erzeugung einer Elektrode auf der Scheibenseite, unter deren Oberfläche die isolierenden Ringzonen liegen, durch eine zum Lochfeld ausgerichtete Maske mit UV-Licht bestrahlt wird und die unbestrahlten Resistteile in einer Entwicklerlösung abgelöst werden und schließlich auf allen freiliegenden Metalloberflächen eine galvanische Metallabscheidung erfolgt, der Resist entfernt und die darunter liegende Metallisierung selektiv zu den Elektroden abgeätzt wird. Neben der Präzision und Sicherheit des Verfahrens nach der Erfindung besteht der wesentliche Vorteil vor allem darin, daß für den Fotodruck nur eine Resistart, nämlich Fotofolie, verwendet wird und daß die Verarbeitung von Fotofolie weit weniger arbeitsintensiv als die von Fotolacken ist.

Eine weitere Ausgestaltung des erfindungsgemäßen Verfahrens besteht darin, daß auf der Scheibe beidseitig Elektroden erzeugt werden, in dem auf die nicht kaschierte Scheibenseite ebenfalls Trockenresist aufgebracht und durch eine ausgerichtete Maske bestrahlt wird.

Nach einer Weiterbildung der Erfindung wird die in die Bohrungen eindringende Resistmenge durch die zur Verfügung stehenden Einflußgrößen gesteuert. Hierzu gehören folgende Einflußgrößen :

I. Flächenverhältnis Lochquerschnitt zu metallisiertem Glas an der Scheibenoberfläche,
II. Resistart,
III. Resistdicke,
IV. Temperatur der Kaschierwalze,
V. Kaschiergeschwindigkeit,
VI. Anpreßdruck der Kaschierwalze und
VII. Temperatur der Scheibe.

In der Praxis sind die Größen I, II, III durch die Geometrie der Scheibe und den gewählten Resist konstant, häufig auch die Größen V und VI als Geräteparameter, so daß die in den Bohrungen eindringende Resistmenge über die gewählte Kaschier- und Plattentemperatur bestimmt wird.

Für die spätere Elektroplattierung ist es wichtig, daß der Resist dicht an den Bohrungswänden anliegt. Das wird nach der Erfindung durch Aufheizen der Scheibe unmittelbar vor dem Kaschieren mit Fotofolie (z. B. 130 °C), oder durch Nachtempern der kaschierten Scheibe (z. B. 130 °C, 1 min) erreicht. In beiden Fällen wird der Resist kurzzeitig verflüssigt, wodurch sich auch seine Oberflächenform in den Bohrungen gegenüber der auf kalt behandelten Scheiben ändert.

Bei dem bisher beschriebenen Verfahren reicht der Isolatorbereich bis an die Bohrungsmündung. Die Höhe des Ringisolators wird bestimmt durch die Eindringtiefe des Resists in die Bohrungen. Da dieser Betrag auf einer Scheibe z. B. im Lochfeld und an den Lochfeldrändern, und vor allem von Scheibe zu Scheibe etwas variiert, kann es erforderlich sein, die Isolatorhöhen mit größerer Gleichmäßigkeit zu erzeugen.

Ebenso kann es erforderlich sein, daß der Ringisolator die Mündung der Bohrung nicht mehr enthält. Das ist z. B. der Fall, wenn die Materialstege zwischen den Bohrungen so schmal sind, daß der Ringisolator die Mündung der Bohrung nicht mehr enthält. Das ist z. B. der Fall, wenn die Materialstege zwischen den Bohrungen so schmal sind, daß die Breite der zeilen- oder spaltenweise über die Bohrungen führenden Leiterbahnen etwa dem Bohrungsdurchmesser entspricht. Dann muß noch ein Teil der Bohrungswand zur Leiterbahn gehören, weil sonst ihr Querschnitt zu sehr eingeschnürt würde.

Im Rahmen einer weiteren Ausgestaltung der Erfindung soll es daher möglich sein, einerseits die in die Bohrungen eingebrachte Resistmenge im Lochfeld und an den Lochfeldrändern gleich zu halten und andererseits den Isolierring vollständig in die Bohrung zu verlagern und seine Höhe exakt konstant zu halten. Dies geschieht nach der Erfindung dadurch, daß vom Resist der kaschierten Scheibe die Schutzfolie abgezogen und anschließend die Scheibe nachgetempert wird. Der Vorteil dieses Verfahrens besteht darin, daß der Resist jetzt überall gleichmäßig in die Bohrungen eintreten kann. Die Gestalt seiner Oberfläche stellt sich nur noch aufgrund seiner Oberflächenspannung bei der geringsten auftretenden Viskosität ein. Durch diese Maßnahme wird außerdem erreicht, daß der Resist, bezogen auf die Stärke an der Oberfläche, die größte mögliche Eindringtiefe in die Bohrung erreicht, denn über der Bohrung bildet sich eine konkave Resistoberfläche aus.

Zur Lösung der erfindungsgemäßen Aufgabe ist ferner vorgesehen, daß die Bestrahlung des Resists in den Bohrungen nur solange erfolgt, daß der Resist an und über der Bohrungsmündung im Entwickler abgetragen wird. Konstanz der Isolatorhöhe und vollständige Verlagerung in die Bohrung wird erreicht, indem man den Resist bei der Bestrahlung mit UV-Licht nicht in voller Stärke durchhärtet, das heißt, indem man die Belichtungszeit so wählt, daß ein Teil des Resists über der Bohrung vom Entwickler abgetragen wird.

Nach einer Weiterbildung der Erfindung erfolgt das Einbringen der Scheibe in den Elektrolyten vor der galvanischen Metallabscheidung in einer Unterdruckkammer. Die Abscheidung selbst erfolgt bei Umgebungsdruck. Auf diese Weise wird erreicht, daß der Elektrolyt in die Bohrungen eindringen kann.

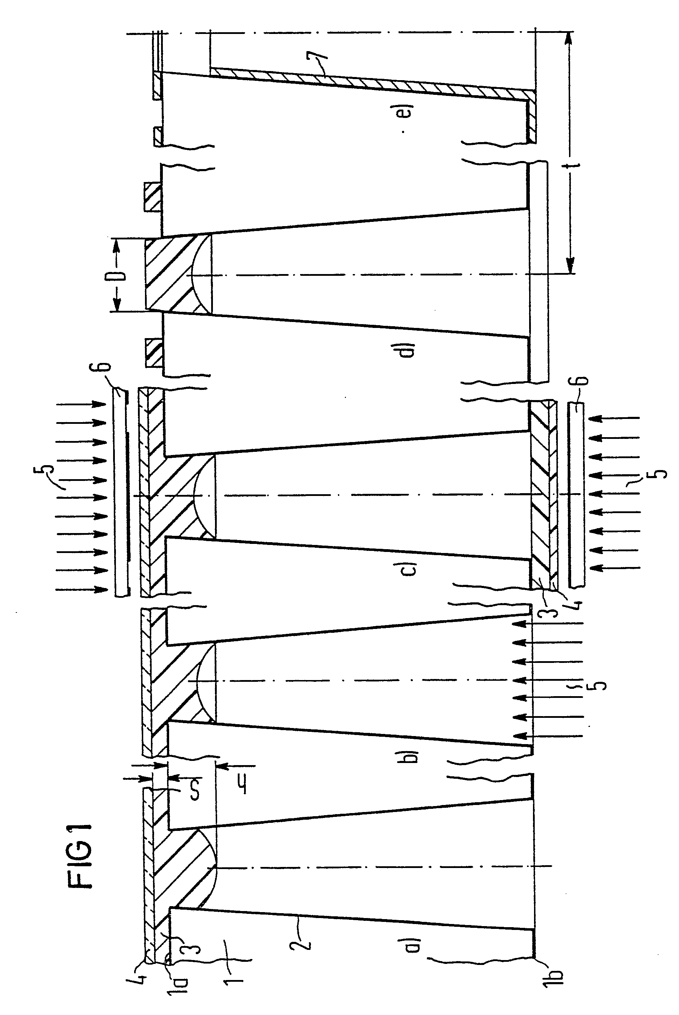

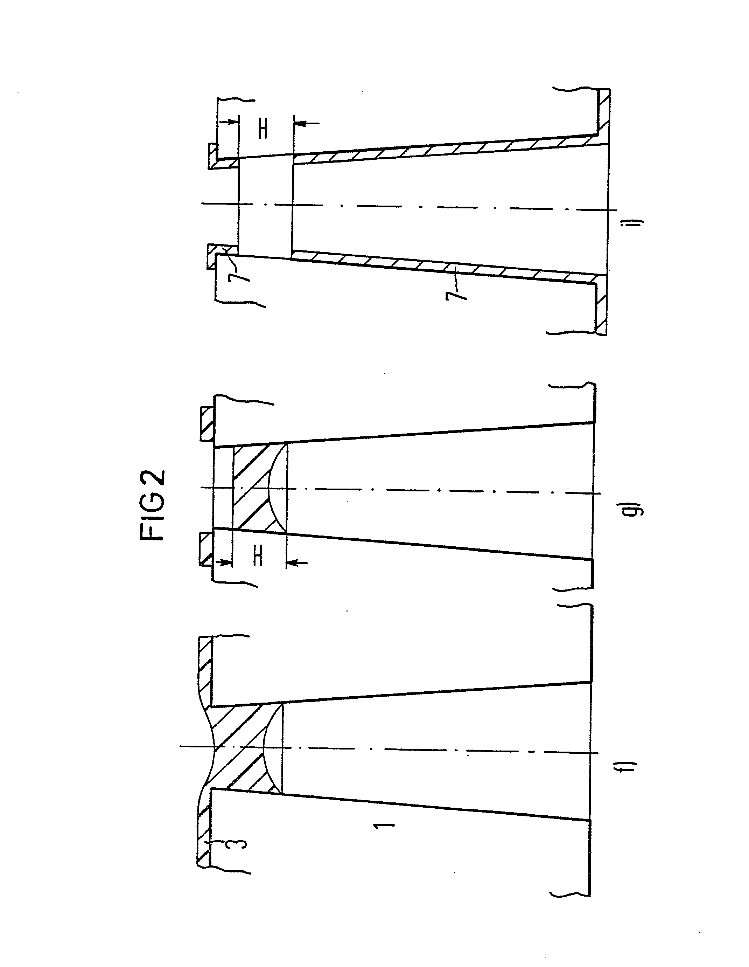

Die Erfindung wird anhand der Figuren 1 und 2 erläutert. In der Figur 1 sind in den Skizzen a bis e die einzelnen Verfahrensschritte an einem Loch mit einseitiger Verengung dargestellt.

Die Figur 2 zeigt zwei Varianten f und g in der Fortzählung der Verfahrensschritte und das Endergebnis i der vorliegenden Erfindung. Dabei ist aber zu berücksichtigen, daß der Schritt f nach der Figur 2 im Verfahrensablauf zwischen a und b der Figur 1 erfolgen muß und der Schritt g den Verfahrensschritt d der Figur 1 ersetzt.

In der Scheibe 1, die z. B. aus Fotoformglas mit 1 mm Stärke besteht, sind eine Vielzahl durchgehender Bohrungen angeordnet. Diese Bohrungen werden auf bekannte Weise durch ein- oder zweiseitiges Ätzen in das Werkstück 1 eingrebracht und können im Querschnitt rund, oval oder eckig sein.

Die gesamte Werkstückoberfläche einschließlich der Bohrungswände wird zunächst in an sich bekannter Weise, z. B durch Sputtern, mit einer dünnen Metallschicht 2 überzogen. Die Scheibenseite 1a, unter deren Oberfläche ein Isolierring erzeugt werden soll, wird mit einem Negativ-Trockenresist (Fotofolie) 3 so kaschiert, daß ein Teil des Resists in die Bohrungen eindringt, wie aus der Darstellung a zu ersehen ist. Auf dem Resist befindet sich eine transparente Schutzfolie 4. Die eingedrungene Resistmenge hängt von den genannten Einflußgrößen ab und kann durch sie reproduzierbar gesteuert werden. In der Regel wird die in den Bohrungsraum eindringende Resistmenge über die gewählte Kaschier- und Plattentemperatur bestimmt. Ein Vergleich der verbleibenden Reststärke s an der Scheibenoberfläche 1a zur ursprünglichen Stärke ergibt die von den Bohrungen aufgenommene Resistmenge. Über das Verhältnis von Lochquerschnitt zu metallisierter Oberfläche läßt sich die Eindringtiefe h errechnen. Für die spätere Elektroplattierung ist es wichtig, daß die Resistschicht an den Bohrungswänden anliegt. Das wird entweder durch Aufheizen der Scheibe 1 unmittelbar vor dem Kaschieren mit Fotofolie (z. B 130 °C) oder durch Nachtempern der kaschierten Scheibe (z. B. 130 °C, 1 min) erreicht. In beiden Fällen wird der Resist kurzzeitig verflüssigt, wodurch sich auch seine Oberflächenform in den Bohrungen gegenüber der auf kalt behandelten Scheiben ändert (Skizze a und b).

Nach dem Verfahrensschritt a (Figur 1) kann entweder die Schutzfolie 4 auf dem Resist bleiben (Figur 1), oder sie kann vor dem Nachtempern, zur Erzielung einer gleichmäßigeren und größeren Eindringtiefe des Resist in die Bohrungen, abgezogen werden (Figur 2f). Zur Erzeugung des Isolierringes wird der Resist 3 in den Bohrungen von der gegenüberliegenden Seite 1b her durch die Bohrungen mit UV-Licht 5 bestrahlt. Eine Maske ist dazu nicht notwendig, da deren Funktion die Scheibe selbst übernimmt (Skizze b).

Anschließend bringt man auf die bisher nicht kaschierte Scheibenseite 1b ebenfalls Negativ-Resist 3 auf. Dabei können die Kaschierparameter so gewählt werden, daß wenig Resist in die Bohrungen gelangt (Skizze c). Das ist jedoch nicht wesentlich, weil eingedrungener Resist beim Entwickeln wieder entfernt wird. Zur Erzeugung der beidseitigen Elektroden werden jetzt beide Seiten der Scheibe durch zum Lochfeld ausgerichtete Masken 6 mit UV-Licht bestrahlt (Skizze c).

Soll nur die Scheibenseite über dem Ringisolator strukturiert und die Gegenseite ganzflächig metallisiert werden (Potentialebene), so entfällt das Kaschieren der Scheibenseite 1b mit Fotoresist.

Nach Entfernung der Schutzfolien 4 werden die unbestrahlten Resistteile in einer Entwicklerlösung abgelöst (Skizze d). Anschließend erfolgt auf allen freiliegenden Metalloberflächen eine galvanische Abscheidung 7. Damit der Elektrolyt in die Bohrungen eindringen kann, geschieht das Eintauchen der Scheibe 1 in einer Unterdruckkammer, aus der die Luft weitgehend evakuiert ist. Zum Schluß wird der Resist entfernt und die darunterliegende Metallisierung selektiv zu den Elektroden abgeätzt (Skizze e). In der Skizze d ist mit D der Durchmesser eines Isolierringes bezeichnet.

Wird der Isolierring einerseits vollständig in die Bohrung verlagert und andererseits seine Höhe exakt konstant mit Hilfe der Bestrahlungszeit erzeugt, so ergibt sich anstelle von d in der Figur 1 eine Ausbildung nach Figur 2, g und das Resultat anstelle von e in der Figur 1 in der Figur 2, i. Aus der Figur 2, i ist ersichtlich, daß der Ringisolator nicht mehr bis an die Bohrungsmündung reicht, sondern vollständig in die Bohrung verlagert ist.

In den Verfahrensschritten g und i ist mit H die Höhe des Ringisolators bezeichnet. Sie wird nach der vorliegenden Erfindung über alle Bohrungen mit hoher Konstanz eingehalten.

Obwohl in den Figuren 1 und 2 die Bohrungen konusförmig dargestellt sind, ist das erfindungsgemäße Verfahren auch auf andere Bohrungsformen, z. B. zylindrische oder doppelt konische, anwendbar.

**Patentansprüche**

1. Verfahren zur galvanischen und ätztechnischen Strukturierung von Scheiben mit isolierenden Ringzonen im Mündungsbereich von Bohrungen, dadurch gekennzeichnet, daß die gesamte Scheibenoberfläche einschließlich der Bohrungswände in an sich bekannter Weise, zum Beispiel durch Sputtern, mit einer dünnen Metallschicht (2) überzogen wird, anschließend die Scheibenseite (1a), unter deren Oberfläche isolierende Ringzonen erzeugt werden sollen, mit einem Negativ-Trockenresist (Fotofolie) (3) so kaschiert wird, daß ein Teil des Resists auch in die Bohrungen eindringt, daß ferner der Resist in den Bohrungen von der gegenüberliegenden Seite (1b) her durch die Bohrungen mit UV-Licht (5) bestrahlt und zur Erzeugung einer Elektrode auf der Scheibenseite (1a), unter deren Oberfläche die isolierenden Ringzonen liegen, durch eine zum Lochfeld ausgerichtete Maske (6) mit UV-Licht (5) bestrahlt wird und die unbestrahlten Resistteile in einer Entwicklerlösung abgelöst werden und schließlich auf allen freiliegenden Metalloberflächen eine galvanische Metallabscheidung (7) erfolgt, der Resist entfernt und die darunter liegende Metallisierung selektiv zu den Elektroden abgeätzt wird.

2. Verfahren nach Anspruch 1, dadurch gekennzeichnet, daß auf der Scheibe (1) beidseitige Elektroden erzeugt werden, in dem auf die nicht kaschierte Scheibenseite (1b) ebenfalls Trockenresist aufgebracht und durch eine ausgerichtete Maske (6) bestrahlt wird.

3. Verfahren nach Anspruch 1 und 2, dadurch gekennzeichnet, daß die in die Bohrungen eindringende Resistmenge durch die zur Verfügung stehenden Einflußgrößen gesteuert wird.

4. Verfahren nach Anspruch 1 und 2, dadurch gekennzeichnet, daß die Scheibe (1) unmittelbar vor dem Kaschieren mit Fotofolie (3) aufgeheizt wird.

5. Verfahren nach Anspruch 1 und 2, dadurch gekennzeichnet, daß die kaschierte Scheibe (1) nachgetempert wird.

6. Verfahren nach Anspruch 5, dadurch gekennzeichnet, daß vom Resist (3) der kaschierten Scheibe die Schutzfolie (4) abgezogen und anschließend die Scheibe (1) nachgetempert wird.

7. Verfahren nach den Ansprüchen 1 und 2, dadurch gekennzeichnet, daß die Bestrahlung des Resists (3) in den Bohrungen lange genug erfolgt, so daß über der Bohrung kein Resist vom Entwickler abgetragen wird.

8. Verfahren nach den Ansprüchen 1 und 2, dadurch gekennzeichnet, daß die Bestrahlung des Resists (3) in den Bohrungen nur solange erfolgt, daß der Resist an und über der Bohrungsmündung vom Entwickler abgetragen wird.

9. Verfahren nach den Ansprüchen 1 und 2, dadurch gekennzeichnet, daß die fototechnisch präparierte Scheibe vor der galvanischen Metallabscheidung (7) bei Unterdruck in den Elektrolyten eingebracht wird.

**Claims**

1. A process for structuring discs with isolating annular zones in the opening region of bores, using electrolytic and etching techniques, characterised in that the entire surface of the disc, including walls of the bores are coated with a thin metal layer (2) in a manner known per se, for example, by sputtering, the face (1a) of the disc, below the surface of which isolating annular zones are to be produced, is subsequently covered with a negative dry resist (photofilm) (3) in such a way that a portion of the resist even penetrates into the bores ; that further the resist in the bores is irradiated with UV-light (5) through the bores from the opposite face (1b) and, in order to produce an electrode on the disc face (1a) below the surface of which the isolating annular zones are arranged, is irradiated with UV-light (5) through a mask (6) wich is aligned with the opening array, the non-irradiated resist portions dissolved in a developing solution, an electrodeposition of metal (7) finally takes place on all exposed metal surfaces, the resist is removed, and the underlying metallization is selectively etched away to form the electrodes.

2. A process as claimed in Claim 1, characterised in that electrodes are produced on both faces of the disc (1), in that dry resist is similarly applied to the disc face (1b), which is not convered, and is irradiated through an aligned mask (6).

3. A process as claimed in Claim 1 and Claim 2, characterised in that the amount of resist which penetrates into the bores is controlled by the inflowing quantities available.

4. A process as claimed in Claim 1 and Claim 2, characterised in that the disc (1) is heated immediately prior to covering with photo-film (3).

5. A process as claimed in Claim 1 and Claim 2, characterised in that the covered disc (1) is subsequently annealed.

6. A process as claimed in Claim 5, characterised in that the protective film (4) is removed from the resist (3) of the covered disc and the disc (1) is then subsequently annealed.

7. A process as claimed in Claims 1 and 2, characterised in that the irradiation of the resist (3) in the bores is effected for a long enough time that no resist is removed by the developer above the bore.

8. A process as claimed in Claims 1 and 2, characterised in that the irradiation of the resist (3) in the bores is only effected until the resist is removed by the developer on and above the opening of the bore.

9. A process as claimed in Claims 1 and 2, characterised in that, prior to the metal electrodeposition (7), the disc prepared using the phototechnique is inserted into the electrolyte under reduced pressure.

**Revendications**

1. Procédé de structuration, par galvanoplastie et par la technique de décapage, de disques ayant des zones annulaires isolantes dans la région de l'embouchure de perçages, caractérisé en ce qu'il consiste à revêtir, d'une manière en soi connue, par exemple par pulvérisation cathodique, toute la surface du disque, y compris les parois des perçages, d'une mince couche métallique (2), à plaquer ensuite sur le côté du disque (1a), sous la surface duquel il faut produire des zones annulaires isolantes, un resist sec négatif (feuille photosensible) (3) de manière à ce qu'une partie du resist pénètre également dans les perçages, à exposer en outre le resist dans les perçages, par le côté opposé (1b), à de la lumière ultraviolette (5) passant à travers les perçages et, pour produire une électrode sur le côté du disque (1a), sous la surface duquel se trouvent les zones annulaires isolantes, à exposer le resist à de la lumière ultraviolette (5) à travers un masque (6) aligné sur le réseau de perforations et à dissoudre dans une solution de révélateur la partie du resist qui n'a pas été exposée et enfin à effectuer sur toutes les surfaces métalliques dénudées un dépôt métallique (7) par galvanoplastie, à éliminer le resist et à attaquer sélectivement la métallisation sous-jacente pour obtenir les électrodes.

2. Procédé suivant la revendication 1, caractérisé en ce qu'il consiste à produire sur le disque (1), des deux côtés, des électrodes, en déposant également un resist sec sur le côté du disque (1b), qui n'est pas plaqué et en exposant à travers un masque (6) aligné.

3. Procédé suivant les revendications 1 et 2, caractérisé en ce qu'il consiste à se rendre maître de la quantité de resist qui pénètre dans les perçages par les grandeurs d'influence, dont on dispose.

4. Procédé suivant les revendications 1 et 2, caractérisé en ce qu'il consiste à chauffer le disque (1) immédiatement avant le placage de la feuille photosensible (3).

5. Procédé suivant les revendications 1 et 2, caractérisé en ce qu'il consiste à faire subir ensuite un recuit au disque (1) plaqué.

6. Procédé suivant la revendication 5, caractérisé en ce qu'il consiste à enlever la feuille de protection (4) du resist (3) du disque plaqué et, ensuite, à recuire le disque.

7. Procédé suivant les revendications 1 et 2, caractérisé en ce qu'il consiste à effectuer l'exposition du resist (3) dans les perçages suffisamment longtemps pour qu'aucun resist ne soit enlevé par le révélateur sur le perçage.

8. Procédé suivant les revendications 1 et 2, caractérisé en ce qu'il consiste à effectuer l'exposition du resist (3) dans les perçages que jusqu'à ce que le resist dans et sur l'embouchure du perçage soit enlevé par le révélateur.

9. Procédé suivant les revendications 1 et 2, caractérisé en ce qu'il consiste à introduire le disque préparé par la technique photographique dans l'électrolyte sous dépression avant le dépôt métallique par galvanoplastie (7).

FIG 1

0 064 744

# FIG 2

f)

g)

i)

0 064 744